# FASCICULE DE BREVET EUROPEEN

(11) **EP 0 867 966 B1**
(45) Date de publication et mention de la délivrance du brevet: **09.07.2003**
(21) Numéro de dépôt: 97104960.6
(22) Date de dépôt: 24.03.1997
(51) Int. Cl.: H01Q 1/00, H01Q 7/00, H01Q 1/52, H05K 9/00

(54) **Structure monolithique améliorée de circuits intégrés et de bobine d'antenne, munie d'un anneau de protection périphérique**
Monolithische Struktur mit integrierten Schaltungen und einer Antennenspule, versehen mit einem aüsseren Schutzring
Monolithic structure comprising integrated circuits and an antenna coil with an outer protection ring

(43) Date de publication de la demande: 30.09.1998
(73) Titulaire: EM Microelectronic-Marin SA, 2074 Marin (CH)
(72) Inventeur: Kunz, Pascal, 2000 Neuchâtel (CH)
(74) Mandataire: Balsters, Robert

(56) Documents cités:
- EP-A- 0 376 062
- WO-A-88/00785
- GB-A- 2 101 412
- US-A- 4 237 438
- US-A- 5 198 647

## Description

La présente invention concerne une structure monolithique de circuits intégrés et, plus particulièrement, une structure monolithique comprenant essentiellement une bobine d'antenne pourvue d'un anneau de protection périphérique.

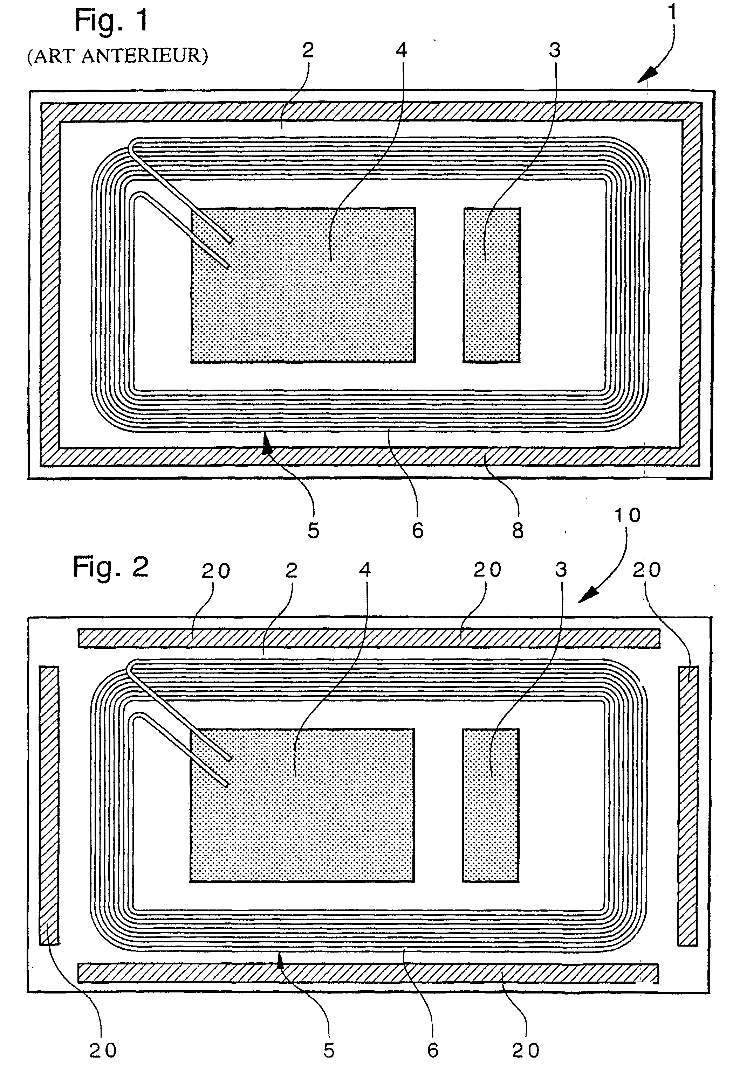

On utilise classiquement des structures comprenant des circuits intégrés et une bobine d'antenne, notamment pour la réalisation d'un émetteur-récepteur que l'on appelle communément "transpondeur". A titre d'exemple, le document WO 88/00785 décrit un dispositif de transpondeur comprenant une structure monolithique 1 formée dans un substrat 2, et constituée de différents circuits intégrés 3, 4 et d'une bobine d'antenne 5, comme le représente la figure 1 à titre illustratif. Dans cet exemple, la bobine 5 est formée par plusieurs spires conductrices 6 qui entourent les différents circuits logiques 3, 4.

En outre, lors de la fabrication du masque destiné à réaliser les structures du type susmentionné, un anneau de protection 8 métallique est communément formé à la périphérie de la structure 1, comme cela est représenté en figure 1. Un anneau de protection de ce type présente normalement de nombreux avantages en ce qu'il protège la structure 1 contre les contraintes mécaniques exercées sur les différentes couches déposées sur le substrat 2 lors du sciage des circuits intégrés formés sur le substrat 2, en ce qu'il permet de réaliser une bonne finition sur les bords des circuits-intégrés, et en ce qu'il évite la corrosion des éléments de circuit intégré 3, 4 et 5.

Toutefois, la demanderesse a constaté, dans de telles structures, que l'anneau de protection métallique forme ce que l'on peut appeler une spire parasite en court-circuit pour les éléments situés à l'intérieur de ladite spire, en particulier la bobine d'antenne. Pour l'essentiel, cette spire parasite entourant la bobine d'antenne affecte notablement l'action de champs extérieurs destinés essentiellement à ladite bobine, ce qui induit des perturbations indésirables sur son fonctionnement.

Il va de soi qu'une structure monolithique de circuit intégré, dans laquelle la bobine n'entoure pas nécessairement tous les éléments de circuit intégré, présente le même dysfonctionnement.

Un objet de la présente invention est de prévoir une structure monolithique de circuit intégré améliorée comprenant notamment une bobine d'antenne et un anneau de protection périphérique, pour éviter un fonctionnement perturbé de cette bobine.

Cet objet, ainsi que d'autres, sont atteints par la structure monolithique de circuit intégré améliorée selon la revendication 1.

Un avantage de la présente invention est de fournir une telle structure munie d'un anneau de protection périphérique non continu tout le long de la périphérie de ladite structure, ce qui évite que ledit anneau réalise un circuit fermé périphérique.

Les objets, caractéristiques et avantages de la présente invention apparaîtront plus clairement à la lecture de la description détaillée d'un mode de réalisation préféré de l'invention, donné à titre d'exemple uniquement, en relation avec les figures jointes, parmi lesquelles :
- la figure 1 déjà citée représente une structure de circuit intégré et de bobine d'antenne selon l'art antérieur; et
- la figure 2 représente une structure de circuit intégré entouré par une bobine d'antenne et un anneau de protection selon la présente invention.

Une structure monolithique de circuit intégré 10 représentée en figure 2 est proche de la structure monolithique de circuit intégré décrite ci-dessus. Par souci de simplicité, les composants représentés en figure 2, et désignés par les mêmes références que ceux représentés en figures 1 sont sensiblement identiques à ceux désignés en figure 1.

La structure de circuit intégré 10 formée de façon monolithique dans un substrat 2 est constituée de différents éléments de circuit intégré 3, 4 et d'une bobine d'antenne 5 formée par plusieurs spires conductrices 6 qui entourent, dans cet exemple, les différents éléments de circuit logique 3, 4.

La structure monolithique de circuit intégré 10 comprend en outre un anneau de protection 20 formé à la périphérie de la structure de circuit intégré 10, par des procédés de fabrication communément connus par l'homme de l'art. L'anneau de protection 20 est conçu de telle sorte qu'il ne réalise pas un circuit fermé sur lui-même. A cet effet, l'anneau de protection 20 est pourvu d'interruptions ohmiques. Il va de soi que les quatre interruptions ohmiques de l'anneau de protection 20 sont seulement représentées à titre illustratif en figure 2.

A titre de variante, on peut prévoir d'autres modes de réalisation de l'anneau de protection 20. Par exemple, la forme de l'anneau de protection peut être modifiée suivant la forme de la structure de circuit intégré à la périphérie de laquelle est formé l'anneau de protection.

Le fait de couper localement l'anneau de protection 20 métallique par au moins une interruption ohmique de l'anneau de protection 20 évite ainsi la formation d'une spire parasite en court-circuit telle que décrite ci-dessus, ce qui rend le fonctionnement de la bobine d'antenne 5 insensible à la présence de l'anneau de protection 20.

## Revendications

1. Structure monolithique de circuit intégré (1) formée dans un substrat (2) et constituée de :
- au moins un élément de circuit intégré (3, 4);
- une bobine d'antenne (5) destinée à émettre et/ou recevoir des données, et associée audit au moins un élément de circuit intégré (3, 4); et
- un anneau de protection (20) métallique situé à la périphérie de la structure de circuit intégré (1);
**caractérisée en ce que** l'anneau de protection (20) comprend au moins une interruption ohmique, de sorte qu'il ne forme pas un circuit fermé sur lui-même, ce qui rend le fonctionnement de la bobine d'antenne (5) insensible à la présence de l'anneau de protection (20).

## Patentansprüche

1. Monolithische Struktur mit integrierter Schaltung (1), die in einem Substrat (2) gebildet ist und umfaßt:
- wenigstens ein integriertes Schaltkreiselement (3, 4);
- eine Antennenspule (5), die zum Senden und/oder Empfangen von Daten bestimmt ist und dem wenigstens einen integrierten Schaltkreiselement (3, 4) zugeordnet ist, und
- einen metallischen Schutzring (20), der am Rand der Struktur mit integrierter Schaltung (1) angeordnet ist,
**dadurch gekennzeichnet, daß** der Schutzring (20) wenigstens eine Ohmische Unterbrechung derart aufweist, daß er keinen in sich geschlossenen Stromkreis bildet, was den Betrieb der Antennenspule (5) unempfindlich gegenüber dem Vorhandensein des Schutzrings (20) macht.

## Claims

1. Integrated circuit structure (1) formed in a semiconductor substrate (2) and including :
- at least one integrated circuit element (3, 4);
- an antenna coil (5) arranged to transmit and/or receive data, and be connected with said at least one integrated circuit element (3, 4); and
- a metal protective ring (20) situated at the periphery of said integrated circuit structure (1);
**characterised in that** said protective ring (20) is arranged with at least one ohmic interruption, so that it does not form a closed circuit on itself, which makes the operation of the antenna coil (5) insensitive to the presence of the protective ring (20).
